# EUROPÄISCHE PATENTSCHRIFT

(11) **EP 1 730 787 B1**
(45) Veröffentlichungstag und Bekanntmachung des Hinweises auf die Patenterteilung: **29.04.2020**
(21) Anmeldenummer: 05738727.6
(22) Anmeldetag: 10.03.2005
(51) Int. Cl.: H01L 31/0216, H01L 31/0687

(54) **STRAHLUNGSDETEKTOR**
RADIATION DETECTOR
DETECTEUR DE RAYONNEMENTS

(30) Priorität: 31.03.2004 DE 102004015931; 30.07.2004 DE 102004037020; 04.11.2004 DE 102004053317
(43) Veröffentlichungstag der Anmeldung: 13.12.2006
(73) Patentinhaber: OSRAM Opto Semiconductors GmbH, 93055 Regensburg (DE)
(72) Erfinder: JAEGER, Arndt, 93051 Regensburg (DE); STAUSS, Peter, 93186 Pettendorf (DE); WINDISCH, Reiner, 93186 Pettendorf (DE)
(74) Vertreter: Epping - Hermann - Fischer
(86) Internationale Anmeldenummer: PCT/DE2005/000428
(87) Internationale Veröffentlichungsnummer: WO 2005/096394

(56) Entgegenhaltungen:
- EP-A- 0 509 215
- WO-A2-2005/041247
- DE-C- 626 680
- US-A- 4 451 691
- US-A- 4 713 493
- US-A- 4 820 915
- US-A- 5 406 067

## Beschreibung

Die vorliegende Erfindung betrifft einen Strahlungsdetektor zur Detektion von Strahlung gemäß einer vorgegebenen spektralen Empfindlichkeitsverteilung, die ein Maximum bei einer vorgegebenen Wellenlänge λ₀ aufweist, umfassend einen Halbleiterkörper mit einem der Detektorsignalerzeugung dienenden und zum Strahlungsempfang vorgesehenen aktiven Bereich. Insbesondere betrifft die Erfindung einen Strahlungsdetektor zur Detektion von Strahlung gemäß der vorgegebenen spektralen Empfindlichkeitsverteilung des menschlichen Auges.

Zur Detektion von Strahlung mit einer vorgegebenen spektralen Empfindlichkeitsverteilung, die ein Maximum bei einer vorgegebenen Wellenlänge λ₀ aufweist, werden oftmals Strahlungsdetektoren mit einer speziell angepaßten externen Filteranordnung, wie beispielsweise Interferenzfiltern oder Monochromatoren verwendet. Derartige Detektoren zeichnen sich durch eine sehr gute Anpassung an die vorgegebene spektrale Empfindlichkeitsverteilung aus, sind aber in ihrer Handhabung und Herstellung meist vergleichsweise aufwendig und kostenintensiv. Weiterhin haben sie oftmals einen hohen Platzbedarf, so dass sie für Anwendungen auf kleinem Raum nicht oder nur eingeschränkt benutzt werden können.

Ist die vorgegebene spektrale Empfindlichkeitsverteilung die des menschlichen Auges, so wird zur Detektion einfallender Strahlung gemäß dieser Empfindlichkeit häufig eine Silizium-Photodiode benutzt.

Die Empfindlichkeit einer Photodiode hängt unter anderem von den Wellenlängen der einfallenden Strahlung ab. Für Wellenlängen, die größer als eine der Bandlücke entsprechenden Grenzwellenlänge sind, ist die Empfindlichkeit sehr gering, da für einfallende Strahlung in diesem Wellenlängenbereich die Bandlücke des Funktionsmaterials im aktiven Bereich der Diode - beispielsweise Si - größer als die Energie der einfallenden Strahlung ist und diese somit nicht für die Erzeugung von Elektron-Loch-Paaren ausreicht. Andererseits nimmt die Empfindlichkeit im Bereich kleiner werdender Wellenlängen ab, da mit sinkender Wellenlänge die erzeugten Elektron-Loch-Paare beispielsweise wegen der Oberflächenrekombination vermehrt nicht mehr zum Photostrom beitragen. Im Zwischenbereich weist die Empfindlichkeit der Diode ein Maximum auf, das bei einer herkömmlichen Silizium-Photodiode bei über 800 nm liegen kann.

Die Verwendung einer derartigen Silizium-Photodiode als Detektor mit der spektralen Empfindlichkeitsverteilung des helladaptierten menschlichen Auges, das ein Maximum der Empfindlichkeit bei etwa 555 nm aufweist, erfordert zusätzlichen Aufwand, da die Wellenlängen der Empfindlichkeitsmaxima stark voneinander abweichen und die beiden spektralen Empfindlichkeitsverteilungen deshalb vergleichsweise schlecht aneinander angepasst sind. Die Anpassung der Detektorempfindlichkeit an die Empfindlichkeitsverteilung des menschlichen Auges kann durch zusätzliche Filter verbessert werden. In der Summe resultiert daraus annähernd die Empfindlichkeitsverteilung des menschlichen Auges.

Es ist eine Aufgabe der Erfindung, einen Strahlungsdetektor der oben genannten Art anzugeben, der vereinfacht herstellbar ist. Weiterhin ist es eine Aufgabe der Erfindung, einen Strahlungsdetektor der oben genannten Art mit verringertem Platzbedarf anzugeben.

Diese Aufgabe wird durch einen Strahlungsdetektor mit den Merkmalen des Patentanspruchs 1 gelöst. Die Erfindung ist durch den Patentanspruch 1 definiert. Weitere vorteilhafte Ausgestaltungen und Weiterbildungen der Erfindung sind Gegenstand der abhängigen Ansprüche.

Im Folgenden werden Teile der Beschreibung und Zeichnungen, die sich auf Ausführungsformen, Ausgestaltungen und Weiterbildungen beziehen, die nicht von den Ansprüchen abgedeckt sind, nicht als Ausführungsformen, Ausgestaltungen und Weiterbildungen der Erfindung präsentiert, sondern als Beispiele, die zum Verständnis der Erfindung nützlich sind.

Erfindungsgemäß umfasst der Strahlungsdetektor zur Detektion von Strahlung gemäß einer vorgegebenen spektralen Empfindlichkeitsverteilung, die ein Maximum bei einer vorgegebenen Wellenlänge λ₀ aufweist, einen Halbleiterkörper mit einem der Detektorsignalerzeugung dienenden und zum Strahlungsempfang vorgesehenen aktiven Bereich, wobei der aktive Bereich eine Mehrzahl von Funktionsschichten umfasst, die Funktionsschichten unterschiedliche Bandlücken und optional unterschiedliche Dicken aufweisen.
Die vorgegebene spektrale Empfindlichkeitsverteilung ist die des menschlichen Auges.

In einer weiteren bevorzugten Ausgestaltung der Erfindung enthält der Halbleiterkörper, insbesondere der aktive Bereich oder die Funktionsschichten, mindestens ein III-V-Halbleitermaterial, beispielsweise aus einem der Materialsysteme InₓGa_{y}Al_{1-x-y}P, InₓGa_{y}Al_{1-x-y}N oder
InₓGa_{y}Al_{1-x-y}As, jeweils mit 0≤x≤1, 0≤y≤1 und x+y≤1. Weiterhin kann der Halbleiterkörper, insbesondere der aktive Bereich oder die Funktionsschichten, ein Material aus dem Materialsystem In_{y}Ga_{1-y}AsₓP₁₋ₓ mit 0≤x≤1 und 0≤y≤1 enthalten.

Zweckmäßigerweise wird ein III-V-Halbleitermaterial verwendet, das Bandlücken im Bereich der Wellenlänge λ₀ beziehungsweise im Bereich der vorgegebenen spektralen Empfindlichkeitsverteilung aufweisen kann.

Die genannten III-V-Halbleitermaterialien sind besonders für Strahlungen im ultravioletten (z.B. InₓGa_{y}Al_{1-x-y}N) über den sichtbaren (InₓGa_{y}Al_{1-x-y}N, InₓGa_{y}Al_{1-x-y}As, InₓGa_{y}Al_{1-x-y}P) bis in den infraroten (z.B. InₓGa_{y}Al_{1-x-y}P oder InₓGa_{y}Al_{1-x-y}As) Spektralbereich besonders geeignet. Ist die vorgegebene spektrale Empfindlichkeitsverteilung die des menschlichen Auges, so eignen sich als Materialsysteme besonders InₓGa_{y}Al_{1-x-y}As oder InₓGa_{y}Al_{1-x-y}P. Im Materialsystem InₓGa_{y}Al_{1-x-y}P können besonders hohe Quanteneffizienzen erzielt werden.

In einer weiteren bevorzugten Ausgestaltung der Erfindung enthält der Halbleiterkörper, insbesondere der aktive Bereich oder die Funktionsschichten, mindestens ein
II-VI-Halbleitermaterial, etwa ein Halbleitermaterial aus dem Materialsystem Zn_{y}Mg_{1-y}SₓSe₁₋ₓ mit 0≤x≤1 und 0≤y≤1. Auch II-VI-Halbleitermaterialien können für oben genannte Spektralbereiche geeignet sein. III-V-Halbleitermaterialien zeichnen sich jedoch gegenüber II-VI-Halbleitermaterialien oftmals durch vereinfacht verwirklichbare hohe Quanteneffizienzen aus.

In einer zweiten Ausführungsform umfasst ein erfindungsgemäßer Strahlungsdetektor zur Detektion von Strahlung gemäß der vorgegebenen spektralen Empfindlichkeitsverteilung des menschlichen Auges, die ein Maximum bei der Wellenlänge λ₀ aufweist, einen Halbleiterkörper mit einem der Detektorsignalerzeugung dienenden und zum Strahlungsempfang vorgesehenen aktiven Bereich, wobei der Halbleiterkörper mindestens ein III-V-Halbleitermaterial enthält und der aktive Bereich eine Mehrzahl von Funktionsschichten umfasst.

Bevorzugt sind die Funktionsschichten zumindest teilweise so ausgebildet, dass sie Strahlung in einem Wellenlängenbereich absorbieren, der Wellenlängen größer als die Wellenlänge λ₀ umfasst und/oder zumindest teilweise unterschiedliche Bandlücken und/oder Dicken aufweisen.

Auf einen der in den obigen Ausführungsformen beschriebenen Strahlungsdetektoren einfallende Strahlung kann von den Funktionsschichten absorbiert werden, wobei die Dicke der jeweiligen Funktionsschicht den Anteil der in ihr absorbierten Strahlungsleistung und die Bandlücke die Wellenlänge der absorbierten Strahlung bestimmt. Über die Ausgestaltung der Funktionsschichten kann der aktive Bereich so ausgebildet werden, dass sich das vom Strahlungsdetektor erzeugte Signal (z. B. der Photostrom oder davon abhängige Größen) gemäß der vorgegebenen spektralen Empfindlichkeitsverteilung verhält. Insbesondere gilt dies vorzugsweise für die langwellige Seite der vorgegebenen spektralen Empfindlichkeitsverteilung mit Wellenlängen größer als λ₀.

Auf externe Filter - Filter, die außerhalb des Halbleiterkörpers angeordnet sind - zur Anpassung der Detektorempfindlichkeit an die vorgegebene spektrale Empfindlichkeitsverteilung, insbesondere deren langwellige Seite, kann mit Vorteil verzichtet werden. Eine aufwendige Filterung mit externen Filtern erfolgt insbesondere häufig bei herkömmlichen Si-Photodioden. Ein Verzicht auf externe Filter ermöglicht eine platzsparende Ausbildung des Strahlungsdetektors.

Weiterhin kann die Stärke des Detektorsignals eines derartigen Strahlungsdetektors verglichen mit Strahlungsdetektoren mit externen optischen Filtern vorteilhaft erhöht sein, da auch langwellige Strahlung bedingt durch einen Verzicht auf externe optische Filter vermehrt Signale erzeugen kann.

Dem aktiven Bereich ist eine Filterschichtstruktur nachgeordnet, die zumindest eine Filterschicht umfasst. Die Filterschichtstruktur bestimmt die kurzwellige Seite der Detektorempfindlichkeit gemäß der vorgegebenen spektralen Empfindlichkeitsverteilung durch Absorption von Strahlung in einem Wellenlängenbereich, der Wellenlängen kleiner als λ₀ umfasst.

Über die Filterschichtstruktur kann mit Vorteil die Empfindlichkeit des Strahlungsdetektors, insbesondere auf der kurzwelligen Seite für Wellenlängen kleiner als λ₀ an die vorgegebene spektrale Empfindlichkeitsverteilung angepasst werden.

Ein erfindungsgemäßer Strahlungsdetektor zur Detektion von Strahlung gemäß einer vorgegebenen spektralen Empfindlichkeitsverteilung, die ein Maximum bei einer vorgegebenen Wellenlänge λ₀ aufweist, umfasst gemäß einer weiteren Ausführungsform einen Halbleiterkörper mit einem der Detektorsignalerzeugung dienenden und zum Strahlungsempfang vorgesehenen aktiven Bereich, wobei dem aktiven Bereich eine Filterschichtstruktur nachgeordnet ist, die zumindest eine Filterschicht umfasst, und die Filterschichtstruktur die kurzwellige Seite der Detektorempfindlichkeit gemäß der vorgegebenen spektralen Empfindlichkeitsverteilung durch Absorption von Wellenlängen in einem Wellenlängenbereich bestimmt, der Wellenlängen kleiner als λ₀ umfasst.

Die vorgegebene spektrale Empfindlichkeitsverteilung ist die des menschlichen Auges.

In einer weiteren bevorzugten Ausgestaltung enthält der Halbleiterkörper mindestens ein III-V- oder II-VI-Halbleitermaterial.

Der aktive Bereich umfasst eine Mehrzahl von Funktionsschichten. Die Funktionsschichten weisen unterschiedliche Bandlücken auf. In einer bevorzugten Ausgestaltung absorbieren die Funktionsschichten zumindest teilweise Strahlung in einem Wellenlängenbereich, der Wellenlängen größer als die Wellenlänge λ₀ umfasst und/oder weisen die Funktionsschichten unterschiedliche Bandlücken und/oder Dicken auf.

Die Filterschichtstruktur bestimmt demnach die kurzwellige Seite der Detektorempfindlichkeit und erleichtert gegebenenfalls in Kombination mit geeigneten Funktionsschichten die Ausbildung eines kleinen und kompakten Strahlungsdetektors mit einer Detektorempfindlichkeit gemäß der vorgegebenen spektralen Empfindlichkeitsverteilung.

In einer weiteren bevorzugten Ausgestaltung der Erfindung weisen zwei beliebige Funktionsschichten unterschiedliche Bandlücken und/oder unterschiedliche Dicken auf.

In einer weiteren bevorzugten Ausgestaltung der Erfindung bestimmen die Funktionsschichten über ihre Ausgestaltung die Detektorempfindlichkeit für Wellenlängen größer als λ₀ gemäß der vorgegebenen spektralen Empfindlichkeitsverteilung.

In einer wiederum weiteren bevorzugten Ausgestaltung der Erfindung ist der Wellenlängenbereich, in dem die Funktionsschichten absorbieren im wesentlichen zusammenhängend und/oder umfasst im wesentlichen Wellenlängen größer als λ₀.

Für verschiedene Wellenlängenbereiche der vorgegebenen Empfindlichkeitsverteilung werden bevorzugt verschieden ausgebildete Funktionsschichten im aktiven Bereich vorgesehen. Besonders bevorzugt weisen die Funktionsschichten - alle oder wenigstens eine - eine Bandlücke auf, der eine Wellenlänge größer als λ₀ entspricht.

Für Wellenlängenbereiche, in denen die vorgegebene Empfindlichkeitsverteilung vergleichsweise hohe Werte annimmt, sind die Funktionsschichten vorzugsweise entsprechend dick ausgebildet, so dass eine entsprechend hohe Strahlungsleistung in diesem Wellenlängenbereich absorbiert wird und folglich ein vergleichsweise hoher Photostrom erzeugt wird. Für Wellenlängenbereiche mit geringeren Werten der vorgegebenen Empfindlichkeitsverteilung sind die Funktionsschichten vorzugsweise entsprechend dünn ausgebildet. Über die Dicke der jeweiligen Funktionsschicht kann die Responsivität des Strahlungsdetektors (die erzeugte Signalstärke bezogen auf die auf den Detektor einfallende Strahlungsleistung) im der jeweiligen Funktionsschicht entsprechenden Wellenlängenbereich gezielt beeinflusst werden und über das Verhältnis der Dicken der Funktionsschichten zueinander die Anpassung der Detektorempfindlichkeit an die vorgegebene spektrale Empfindlichkeitsverteilung, insbesondere auf der langwelligen Seite für Wellenlängen größer λ₀, erfolgen. Besonders bevorzugt weist zumindest eine Funktionsschicht eine Bandlücke im Bereich um die Wellenlänge λ₀ auf, so dass in diesem Bereich ein vergleichsweise hohes Signal erzeugt wird.

Gemäß einer bevorzugten Ausgestaltung der Erfindung nimmt die Bandlücke von im Halbleiterkörper nachgeordneten Funktionsschichten zumindest teilweise in Richtung der einfallenden Strahlung, insbesondere in Richtung der Strahlungseintrittsseite der zu empfangenden Strahlung in den Halbleiterkörper, zu oder ab. Hierdurch wird die Ausbildung eines Strahlungsdetektors mit einer Detektorempfindlichkeit gemäß der vorgegebenen Empfindlichkeit vorteilhaft erleichtert, da die Herstellung des Halbleiterkörpers mit in Richtung der Strahlungseintrittsseite zu- oder abnehmenden Bandlücken der Funktionsschichten gegenüber einer willkürlichen Anordnung der Funktionsschichten vorteilhaft vereinfacht wird.

In einer weiteren bevorzugten Ausgestaltung der Erfindung nimmt die Bandlücke von im Halbleiterkörper nachgeordneten Funktionsschichten zumindest teilweise in Richtung der einfallenden Strahlung zu.

Die Funktionsschichten sind gemäß einer vorteilhaften Weiterbildung der Erfindung so angeordnet, dass die Bandlücken der Funktionsschichten von einem Zentralbereich des aktiven Bereichs ausgehend in vertikaler Richtung zur Strahlungseintrittsseite des Halbleiterkörpers hin und in die entgegengesetzte Richtung zunehmen. Vom Zentralbereich ausgehend nehmen die Bandlücken der Funktionsschichten vorzugsweise stufenartig zu, so dass sich in Richtung der einfallenden Strahlung und der dieser entgegengesetzten Richtung ein vom Zentralbereich aus stufenartig abfallendes Profil der Bandlücken ergibt. Im Zentralbereich erzeugte Elektron-Loch-Paare können somit aufgrund der verringerten Potentialbarrieren den Zentralbereich vergleichsweise unbehindert verlassen, wodurch die Effizienz des Strahlungsdetektors vorteilhaft erhöht werden kann.

Die Funktionsschichten sind zur Signalerzeugung vorzugsweise in einer Raumladungszone des Halbleiterkörpers angeordnet. Diese Raumladungszone kann mittels und/oder zwischen einer p-leitenden, vorzugsweise hochdotierten, Schicht und einer n-leitenden, vorzugsweise hochdotierten, Schicht gebildet werden.

Zum Detektorsignal tragen bei der Erfindung besonders bevorzugt im wesentlichen nur die in der Raumladungszone des Halbleiterkörpers erzeugten Elektron-Loch-Paare bei.

Weiterhin ist zumindest ein Teil der Funktionsschichten vorzugsweise im wesentlichen undotiert oder intrinsisch ausgebildet. Der Halbleiterkörper entspricht einer pin-Diodenstruktur. Derartige Strukturen zeichnen sich durch vorteilhaft geringe Ansprechzeiten aus.

Der aktive Bereich ist bevorzugt entsprechend einer Heterostruktur, wie einer Einfach- oder Mehrfach-Heterostruktur, ausgebildet. Heterostrukturen können sich durch eine vorteilhaft hohe interne Quanteneffizienz auszeichnen.

In einer weiteren vorteilhaften Ausgestaltung der Erfindung ist die Detektorempfindlichkeit und/oder die vorgegebene spektrale Empfindlichkeitsverteilung in einem zusammenhängenden Wellenlängenbereich von null verschieden.

Die Filterschichtstruktur ist dem aktiven Bereich auf der Strahlungseintrittsseite, insbesondere seitens der Strahlungseintrittsseite, nachgeordnet. Die Filterschichtstruktur ist dem aktiven Bereich derart nachgeordnet, dass vom Strahlungsdetektor zu empfangende Strahlung teilweise durch die Filterschichtstruktur hindurchtritt und nach dem Hindurchtreten zur Signalerzeugung auf den aktiven Bereich trifft. Die Filterschichtstruktur kann zwischen einer Strahlungseintrittsfläche des Strahlungsdetektors und dem aktiven Bereich oder dem Halbleiterkörper angeordnet sein.

Die Filterschichtstruktur ist Teil des Halbleiterkörpers und monolithisch im Halbleiterkörper integriert. Der in der Filterschichtstruktur absorbierte Strahlungsanteil trifft nicht auf den aktiven Bereich und in dem Wellenlängenbereich, in dem die Filterschichtstruktur absorbiert, wird nur ein entsprechend verringertes Signal erzeugt. Mit Vorzug ist die Filterschichtstruktur zwischen der Strahlungseintrittsseite des Halbleiterkörpers und dem aktiven Bereich angeordnet.

Die Filterschichtstruktur enthält bevorzugt ein III-V- oder II-VI-Halbleitermaterial, beispielsweise aus einem der oben genannten Materialsysteme.

In einer bevorzugten Ausgestaltung der Erfindung ist der Wellenlängenbereich, in dem die Filterschichtstruktur absorbiert, im wesentlichen zusammenhängend und/oder umfasst im wesentlichen Wellenlängen kleiner als λ₀. Besonders bevorzugt ist die Bandlücke einer Filterschicht der Filterschichtstruktur größer als die einer der Filterschichtstruktur seitens des Halbleiterkörpers nachgeordneten Funktionsschicht.

In einer ersten vorteilhaften Weiterbildung der Erfindung umfasst die Filterschichtstruktur im wesentlichen eine einzelne Filterschicht, die eine direkte Bandlücke und/oder eine indirekte Bandlücke aufweist. Bevorzugt ist die direkte Bandlücke größer als die Bandlücke einer der Filterschicht seitens des aktiven Bereichs nachgeordneten, insbesondere beliebigen, Funktionsschicht.

Die Filterschicht bestimmt weiterhin mit Vorzug durch Absorption von Strahlung über die indirekte Bandlücke in einem Wellenlängenbereich der Wellenlängen kleiner als λ₀ umfasst, die kurzwellige Seite der Detektorempfindlichkeit. Über die Dicke der Filterschicht kann der Anteil der über die indirekte Bandlücke in der Filterschicht absorbierten Strahlung bestimmt werden. Zweckmäßigerweise beträgt die Dicke der Filterschicht hierzu mehr als 1 µm, insbesondere 10 µm oder mehr.

Die direkte Bandlücke der Filterschicht bestimmt mit Vorzug die kurzwellige Grenze der Detektorempfindlichkeit. Auf den Strahlungsdetektor einfallende Strahlung mit Wellenlängen kleiner der kurzwelligen Grenzwellenlänge wird im wesentlichen vollständig in der Filterschicht absorbiert und im Wellenlängenbereich kleiner der Grenzwellenlänge wird im wesentlichen kein Detektorsignal erzeugt.

GaP- oder AlGaAs-haltige Halbleitermaterialien sind für eine Filterschicht in einem Detektor gemäß der Augenempfindlichkeit besonders geeignet, da sie sowohl eine direkte als auch eine indirekte Bandlücke aufweisen können, die für die Augenempfindlichkeit geeigneten Wellenlängenbereichen entsprechen.

In einer zweiten vorteilhaften Weiterbildung weist die Filterschichtstruktur eine Mehrzahl von Filterschichten, bevorzugt unterschiedlicher Bandlücke und/oder Dicke, auf. Insbesondere können jeweils zwei beliebige Filterschichten der Filterschichtstruktur unterschiedliche Bandlücken und/oder Dicken aufweisen. Besonders bevorzugt bestimmt die Filterschichtstruktur über Absorption von Strahlung über eine direkte Bandlücke der jeweiligen Filterschicht in einem Wellenlängenbereich, der Wellenlängen kleiner als λ₀ umfasst, die kurzwellige Seite der Detektorempfindlichkeit. Besonders bevorzugt ist die Bandlücke, insbesondere die direkte Bandlücke, einer, vorzugsweise beliebigen, Filterschicht der Filterschichtstruktur größer als die einer der Filterschichtstruktur seitens des Halbleiterkörpers nachgeordneten, vorzugsweise beliebigen, Funktionsschicht.

Verglichen mit einer einzelnen Filterschicht, die über die indirekte Bandlücke die kurzwellige Seite der Detektorempfindlichkeit bestimmt, kann mittels einer Mehrzahl von Filterschichten und einer Absorption in der jeweiligen Filterschicht im wesentlichen über deren direkte Bandlücke die Gesamtdicke der Filterschichtstruktur vorteilhaft gering gehalten werden.

Mittels einer Filterschichtstruktur mit einer Mehrzahl von Filterschichten, die eine Dicke von 1 µm oder weniger aufweist, kann bereits eine sehr gute Anpassung der Detektorempfindlichkeit an die vorgegebene spektrale Empfindlichkeitsverteilung erzielt werden.

Weiterhin kann aufgrund der vergleichsweise geringen Schichtdicken der Filterschichten eine abrupte Abnahme der Detektorempfindlichkeit für Wellenlängen kleiner einer kurzwelligen Grenzwellenlänge vermieden werden. Auch für Wellenlängen kleiner der größten direkten Bandlücke der Filterschichten der Filterschichtstruktur kann so noch ein signifikantes Signal erzeugt werden.

Der Halbleiterkörper mit den Funktionsschichten ist gemäß einer weiteren bevorzugten Ausgestaltung monolithisch integriert, beispielsweise durch epitaktisches Aufwachsen auf einem Aufwachssubstrat, hergestellt. Dies erleichtert die Herstellung eines erfindungsgemäßen Strahlungsdetektors.

In einer vorteilhaften Weiterbildung ist der Halbleiterkörper mit dem aktiven Bereich, den Funktionsschichten und der Filterschichtstruktur monolithisch integriert hergestellt. Ein derartiger monolithisch integrierter Halbleiterchip kann demnach so ausgebildet sein, dass die Empfindlichkeit des Halbleiterchips gemäß der vorgegebenen Empfindlichkeitsverteilung ausgebildet ist. Aufgrund eines derart monolithisch integriert ausgebildeten Halbleiterkörpers kann bei dem Strahlungsdetektor auf extern angeordnete Filter, wie Interferenzfilter oder Monochromatoren, mit Vorteil verzichtet werden, was die Ausbildung eines Strahlungsdetektors mit einem geringen Platzbedarf erleichtert.

Die Erfindung kann insbesondere als Umgebungslichtsensor entsprechend der vorgegebenen spektralen Empfindlichkeitsverteilung verwendet werden.

Weitere Verwendungen des Strahlungsdetektors können die Steuerung der Helligkeiten von Beleuchtungseinrichtung oder Anzeigen, sowie des Ein- und/oder Ausschaltzeitpunkts von Beleuchtungseinrichtungen umfassen. Solche Beleuchtungseinrichtungen können als Innen- und Außenraumbeleuchtungen für Wohnungen, Straßen oder Autos sowie die Hinterleuchtungseinrichtungen von Displays, wie etwa Displays von Mobiltelephonen oder sonstigen Telekommunikationsgeräten, Autodisplays, -armaturenbrettern oder LCD-Bildschirmen realisiert sein. Für die letztgenannten Anwendungen ist ein geringer Platzbedarf des Strahlungsdetektors von besonderem Interesse.

Bei den genannten Verwendungen der Erfindung ist die vorgegebene Empfindlichkeit bevorzugt durch die des menschlichen Auges gegeben. Somit können etwa die Helligkeiten der genannten Beleuchtungseinrichtungen - durch Erhöhung oder Erniedrigung der Helligkeit - vorteilhaft entsprechend der Wahrnehmung durch das menschliche Auge gesteuert werden.

Weitere Vorteile, Merkmale und Zweckmäßigkeiten der Erfindung ergeben sich aus der Beschreibung des folgenden Ausführungsbeispiels in Verbindung mit den Figuren.

Es zeigen
- Figur 1: ein erstes Ausführungsbeispiel eines erfindungsgemäßen Strahlungsdetektors anhand einer schematischen Schnittansicht,
- Figur 2: eine qualitative Darstellung des spektralen Verlaufs der vorgegebenen Empfindlichkeitsverteilung des menschlichen Auges und der Detektorempfindlichkeit für zwei Varianten des ersten Ausführungsbeispiels in den Figuren 2a und 2b,
- Figur 3: ein zweites Ausführungsbeispiel eines erfindungsgemäßen Strahlungsdetektors anhand einer schematischen Schnittansicht,
- Figur 4: eine qualitative Darstellung des spektralen Verlaufs der vorgegebenen Empfindlichkeitsverteilung des menschlichen Auges und der Detektorempfindlichkeit für zwei Varianten des zweiten Ausführungsbeispiels in den Figuren 4a und 4b und
- Figur 5: eine quantitative Darstellung eines Vergleichs der vorgegebenen Empfindlichkeitsverteilung des menschlichen Auges und der Detektorempfindlichkeiten für einen Detektor gemäß dem ersten Ausführungsbeispiel und einen Detektor gemäß dem zweiten Ausführungsbeispiel.

Gleichartige und gleich wirkende Elemente sind in den Figuren mit den gleichen Bezugszeichen versehen.

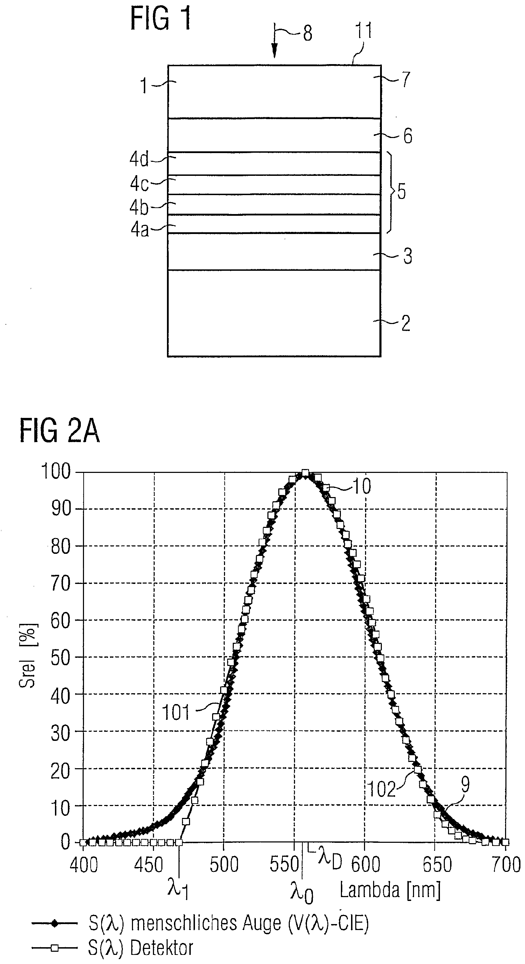

In der Figur 1 ist ein erstes Ausführungsbeispiel eines erfindungsgemäßen Strahlungsdetektors anhand einer schematischen Schnittansicht dargestellt.

Ein Halbleiterkörper 1 ist auf einem Träger 2 angeordnet. Seitens des Trägers 2 ist im Halbleiterkörper eine n-leitende Schicht 3 angeordnet, welcher Funktionsschichten 4a, 4b, 4c und 4d verschiedener Bandlücken und optional unterschiedlicher Dicken nachgeordnet sind, die im wesentlichen den aktiven Bereich 5 des Halbleiterkörpers bilden und der Detektorsignalerzeugung dienen. Bevorzugt weisen jeweils zwei beliebige Funktionsschichten unterschiedliche Bandlücken und Dicken auf. Den Funktionsschichten nachgeordnet ist eine p-leitende Schicht 6 gefolgt von einer Filterschichtstruktur, die eine Filterschicht 7 umfasst. Der Halbleiterkörper mit der Filterschicht der n- und der p-leitenden Schicht und den Funktionsschichten ist bevorzugt monolithisch integriert ausgebildet. Besonders bevorzugt ist der Träger durch das Aufwachssubstrat des Halbleiterkörpers gegeben. Der Halbleiterkörper ist vorzugsweise durch Epitaxie (z.B. MOVPE) auf einem geeigneten Aufwachssubstrat hergestellt.

Der Träger 2 kann jedoch auch vom Aufwachssubstrat des Halbleiterkörpers verschieden sein. Beispielsweise kann der Träger durch eine Schicht gegeben sein, auf der der Halbleiterkörper nach der Herstellung auf dem Aufwachssubstrat auf seiner dem Aufwachssubstrat gegenüberliegenden Seite angeordnet wird. Das Aufwachssubstrat wird vorzugsweise nach der Anordnung des Halbleiterkörpers auf der Trägerschicht abgelöst. Zwischen der Trägerschicht und dem Halbleiterkörper ist vorzugsweise eine Spiegelschicht angeordnet. Diese Spiegelschicht kann ein Metall, beispielsweise Ag, Au, Al, Pt oder eine Legierung mit mindestens einem dieser Materialien enthalten oder daraus bestehen. Die Effizienz des Strahlungsdetektors kann so vorteilhaft erhöht werden. Derartige unter Ablösen des Aufwachssubstrats hergestellte Halbleiterchips werden auch als Dünnfilm-Chips bezeichnet. Die relative Anordnung der n-leitenden und p-leitenden Schichten zu den Funktionsschichten und der Filterschicht ist dann entsprechend der Anordnung des Halbleiterkörpers auf der derartigen Trägerschicht gegebenenfalls in anderer Abfolge als in Figur 1 dargestellt ausgeführt. Die Filterschicht ist gegebenenfalls nach der Anordnung auf dem Träger auf die Struktur mit den Funktionsschichten und der n- und p-leitenden Schicht aufgebracht.

Die n- bzw. p-leitende Schicht ist bevorzugt derart hoch dotiert, dass sich eine ausgedehnte Raumladungszone ausbildet, die von der p-leitenden bis zur n-leitenden Schicht reicht. Die Funktionsschichten sind bevorzugt innerhalb dieser Raumladungszone angeordnet. Eine derartige Raumladungszone kann beispielsweise eine vertikale Ausdehnung von 1100 nm, vorzugsweise 1200 nm oder mehr haben, je nach Konzentration der Dotierstoffe.

Je nach ihrer genauen Ausbildung - insbesondere hinsichtlich Dicke und Bandlücke - können die Funktionsschichten bestimmte Wellenlängen aus einer auf den Halbleiterkörper einfallenden Strahlung 8 absorbieren. Mit der Absorption werden Elektron-Loch-Paare erzeugt, die, sofern sie in der Raumladungszone erzeugt werden, zum Photostrom beitragen. Die Stärke des Photostroms in Abhängigkeit von der Wellenlänge bestimmt hierbei die Empfindlichkeit eines Detektors mit einem derartigen Halbleiterkörper bzw. Halbleiterchip (Halbleiterkörper auf dem Träger) als strahlungsdetektierendem Element.

Die Filterschichtstruktur ist dem aktiven Bereich 5 zweckmäßigerweise seitens der Strahlungseintrittsseite 11, über die bevorzugt der überwiegende Anteil an zu detektierender Strahlung in den Halbleiterkörper eintritt, des Halbleiterkörpers nachgeordnet. Insbesondere kann die Filterschichtstruktur zwischen dem aktiven Bereich 5 und der Strahlungseintrittsseite 11 angeordnet sein.

Über die Filterschicht 7 und die Anordnung und Ausbildung der Funktionsschichten 4a, 4b, 4c und 4d wird die Empfindlichkeit des Halbleiterkörpers auf eine vorgegebene spektrale Empfindlichkeitsverteilung, die ein Maximum bei einer Wellenlänge λ₀ aufweist, abgestimmt.

Die Filterschicht 7 bewirkt hierbei die Anpassung der Detektorempfindlichkeit an die vorgegebene Empfindlichkeit durch Absorption von Wellenlängen der einfallenden Strahlung, die kleiner sind als die Wellenlänge λ₀. Strahlung mit Wellenlängen in diesem Bereich trifft somit nur noch in verminderter Intensität auf den aktiven Bereich und das in diesem Wellenlängenbereich erzeugte Signal wird durch die Absorption an die vorgegebene Empfindlichkeitsverteilung angepasst.

Die durch Absorption von Strahlung in der Filterschicht erzeugten Elektron-Loch-Paare tragen im wesentlichen nicht zum Photostrom bei. Hierzu ist die Filterschicht außerhalb der Raumladungszone angeordnet. Durch eine derartige Anordnung der Filterschicht außerhalb der Raumladungszone wird die Abstimmung der Detektorempfindlichkeit auf die vorgegebene Empfindlichkeitsverteilung vorteilhaft erleichtert, da die Filterschicht von den Funktionsschichten entkoppelt ist und somit die Gefahr eines störenden Einflusses von in der Filterschicht erzeugten Elektron-Loch-Paaren auf den Photostrom, der im Bereich der Funktionsschichten gemäß der vorgegebenen Empfindlichkeitsverteilung erzeugt wird, verringert wird. Der für die Detektorempfindlichkeit maßgebliche Photostrom wird vorzugsweise im wesentlichen im aktiven Bereich erzeugt.

Die Filterschicht 7 bestimmt den Verlauf der kurzwelligen Seite der Detektorempfindlichkeit bevorzugt durch Absorption über eine indirekte Bandlücke. Hierzu ist die Filterschicht zweckmäßigerweise entsprechend dick ausgeführt.

Eine direkte Bandlücke der Filterschicht bestimmt vorzugsweise die kurzwellige Grenze der Detektorempfindlichkeit. Für Wellenlängen kleiner der kurzwelligen Grenze verschwindet die Detektorempfindlichkeit oder ist vernachlässigbar.

Der Photostrom, der in den Funktionsschichten erzeugt wird, bestimmt bevorzugt zumindest die langwellige Seite der Detektorempfindlichkeit gemäß der vorgegebenen Empfindlichkeitsverteilung für Wellenlängen größer als λ₀. Besonders bevorzugt entsprechen die Bandlücken der Funktionsschichten zumindest teilweise Wellenlängen größer als λ₀. Dadurch kann die Abstimmung der Detektorempfindlichkeit auf die vorgegebene Empfindlichkeit auf der kurzwelligen Seite erleichtert werden, da diese dann im wesentlichen nur durch die Filterschicht bestimmt wird und so der Aufwand einer Abstimmung von Funktionsschichten und Filterschicht aufeinander verringert werden kann.

Die Funktionsschichten sind bevorzugt so ausgebildet, dass die für die Absorption maßgebliche Bandlücke der Funktionsschichten mit steigender Entfernung vom Träger zunimmt. Die am weitesten von der Haupteinfallsebene der einfallenden Strahlung 8 auf den Halbleiterkörper beabstandete Funktionsschicht 4a weist demnach vorzugsweise die kleinste Bandlücke unter den Funktionsschichten und die der einfallenden Strahlung 8 zugewandte Funktionsschicht 4d die größte Bandlücke unter den Funktionsschichten auf.

Über die Bandlücke der Funktionsschichten kann die zu absorbierende Wellenlänge bzw. der zu absorbierende Wellenlängenbereich der jeweiligen Funktionsschicht eingestellt werden und die Dicke der Funktionsschicht bestimmt den Anteil an absorbierter Strahlungsleistung und somit den in der jeweiligen Funktionsschicht erzeugten Photostrom. Bevorzugt ist der Halbleiterkörper so ausgerichtet, dass die einfallende Strahlung 8 auf dem Halbleiterkörper größtenteils seitens der als Fensterschicht zum signalerzeugenden Bereich des Halbleiterkörpers dienenden Filterschicht 7 auftrifft.

Ein Strahlungsdetektor mit einem derartigen Halbleiterkörper erlaubt es, die Charakteristik des Strahlungsdetektors über die Anordnung und Ausgestaltung der Filterschicht und der Funktionsschichten gemäß der vorgegebenen Empfindlichkeitsverteilung zu formen. Hinsichtlich der Funktionsschichten gilt dies bevorzugt für die langwellige Seite der Detektorempfindlichkeit, während die Filterschicht 7 bevorzugt die kurzwellige Seite der Detektorempfindlichkeit gemäß der vorgegebenen spektralen Empfindlichkeitsverteilung bestimmt.

Ein derartiger Detektor kann sehr platzsparend und einfach hergestellt werden. Auf zusätzliche externe Filter zur Anpassung an die vorgegebene Empfindlichkeit kann verzichtet werden.

Die Anzahl der Funktionsschichten richtet sich bevorzugt nach der spektralen Breite der vorgegebenen Empfindlichkeitsverteilung. Je breiter die Verteilung, desto höher die Anzahl der Funktionsschichten. Es hat sich gezeigt, dass eine Anordnung von vier unterschiedlichen Funktionsschichten in einer Heterostruktur für die Abstimmung des erzeugten Photostromes auf eine vorgegebene spektrale Empfindlichkeitsverteilung, insbesondere die des menschlichen Auges, oftmals gut geeignet ist.

Der in Figur 1 dargestellte Halbleiterkörper 1 kann mit elektrischen Anschlüssen - beispielsweise auf dem Halbleiterkörper angeordneten Metallisierungen - versehen werden, um das im Halbleiterkörper erzeugte Signal weiter verarbeiten zu können. Die Anschlüsse können dabei auf verschiedenen Seiten des Trägers oder auf der Seite des Trägers mit dem Halbleiterkörper angeordnet sein. Sind die Anschlüsse auf verschiedenen Seiten des Trägers angeordnet, so ist der Träger zur Erhöhung seiner Leitfähigkeit vorzugsweise entsprechend dotiert.

Weiterhin kann der Halbleiterkörper in einem Gehäuse des Strahlungsdetektors angeordnet sein, das den Halbleiterkörper vor schädlichen äußeren Einflüssen schützt. Auch kann der Halbleiterkörper zumindest teilweise von einer Umhüllung umgeben oder umformt sein, die beispielsweise in einer Ausnehmung des Gehäusekörpers angeordnet sein kann. Vorzugsweise enthält eine derartige Umhüllung ein Reaktionsharz, zum Beispiel ein Acryl-, Epoxid- oder Silikonharz oder ein Silikon. Eine Wand der Ausnehmung des Gehäusekörpers kann mit einem reflexionssteigerndem, beispielsweise im wesentlichen metallischem, Material versehen sein, wodurch mit Vorteil die auf den Halbleiterkörper einfallende Strahlungsleistung erhöht wird. Besonders bevorzugt ist der Strahlungsdetektor als oberflächenmontierbares Bauelement (SMD: Surface Mountable Device) ausgeführt.

Der Strahlungsdetektor ist zur Detektion von Strahlung gemäß der Empfindlichkeit des menschlichen Auges ausgebildet, das ein Empfindlichkeitsmaximum bei ungefähr λ₀ = 555 nm (helladaptiert, Tagsehen) oder bei ungefähr λ₀ = 500 nm (dunkeladaptiert, Nachtsehen) besitzt.

Für einen Strahlungsdetektor gemäß der Augenempfindlichkeit, insbesondere des helladaptierten menschlichen Auges, basiert der Halbleiterkörper 1 bevorzugt auf den III-V-Halbleitermaterialsystemen InₓGa_{y}Al_{1-x-y}P oder InₓGa_{y}Al_{1-x-y}As_{.} Die Funktionsschichten 4a, 4b, 4c und 4d sind bevorzugt aus diesen Materialsystemen ausgebildet. Die Bandlücken können hierbei über Variation des Al-Gehalts eingestellt werden, wobei ein höherer Al-Gehalt größeren Bandlücken entsprechen kann. Dies gilt zumindest für Al-Gehalte, für die die genannten Halbleitermaterialsysteme direkte Halbleiter bilden, welche für die Ausbildung der Funktionsschichten bevorzugt sind. Besonders bevorzugt basiert der Halbleiterkörper auf In_{0,5} (Ga₁₋ₓAlₓ)_{0,5}P oder InₓGa_{y}Al_{1-x-y}As, wodurch die Herstellung von Funktionsschichten mit definierter Bandlücke, beispielsweise über Variation des Al-Gehalts, erleichtert werden kann.

Die Filterschicht 7 ist in einem Strahlungsdetektor gemäß der Augenempfindlichkeit vorzugsweise aus AlₓGa₁₋ₓAs (0≤x≤1) oder GaP gebildet. Mit Vorteil können Halbleiterkörper mit den genannten Funktions- bzw. Filterschichtmaterialien monolithisch integriert hergestellt sein. Beispielsweise ist der Träger durch das Aufwachssubstrat gegeben, welches für die oben genannten Materialsysteme beispielsweise GaAs enthalten oder aus GaAs bestehen kann.

Die für die Filterschicht genannten Materialien können eine direkte und eine indirekte Bandlücke aufweisen, wobei die direkte Bandlücke vorzugsweise einer Wellenlänge kleiner als λ₀ entspricht, die besonders bevorzugt die kurzwellige Grenze der Detektorempfindlichkeit bestimmt.

GaP beispielsweise weist eine direkte Bandlücke (E_{G} ≈ 2,73 eV) auf, die einer Wellenlänge von ungefähr 455 nm entspricht, während die direkte Bandlücke (E_{G} ≈ 2,53 eV) von Al_{0,8}Ga_{0,2}As ungefähr 490 nm entspricht. Die Absorption von einfallender Strahlung über die indirekte Bandlücke bestimmt vorzugsweise die kurzwellige Seite der Detektorempfindlichkeit für Wellenlängen kleiner λ₀. Der Anteil der über die indirekte Bandlücke absorbierten Strahlungsleistung kann über die Dicke der Filterschicht beeinflusst werden.

In einer weiteren bevorzugten Ausgestaltung des Strahlungsdetektors oder des Halbleiterkörpers weist dessen Empfindlichkeit ein Maximum bei einer Wellenlänge λ_{D} auf, die bevorzugt um 20 nm, besonders bevorzugt 10 nm, oder weniger von der Wellenlänge λ₀ des Maximums der vorgegebenen spektralen Empfindlichkeitsverteilung abweicht.

Die vorgegebene spektrale Empfindlichkeitsverteilung, die der des menschlichen Auges entspricht, wird häufig so angegeben, dass sie bei der Wellenlänge λ₀ den Wert 1 beziehungsweise 100% annimmt. Die Empfindlichkeit des Detektors, die von der Signalstärke abhängt, wird häufig in Ampere pro Watt der einfallenden Strahlungsleistung angegeben.

Zum Vergleich der Detektorempfindlichkeit mit der vorgegebenen spektralen Empfindlichkeitsverteilung ist es deshalb zweckmäßig, die beiden Empfindlichkeiten so aneinander anzupassen, dass die vorgegebene Empfindlichkeitsverteilung bei λ₀ und die Detektorempfindlichkeit bei λ_{D} den Wert 100% annehmen (relative Empfindlichkeiten). Die vorliegende Beschreibung bezieht sich auf relative Empfindlichkeiten, sofern nichts anderes angegeben ist.

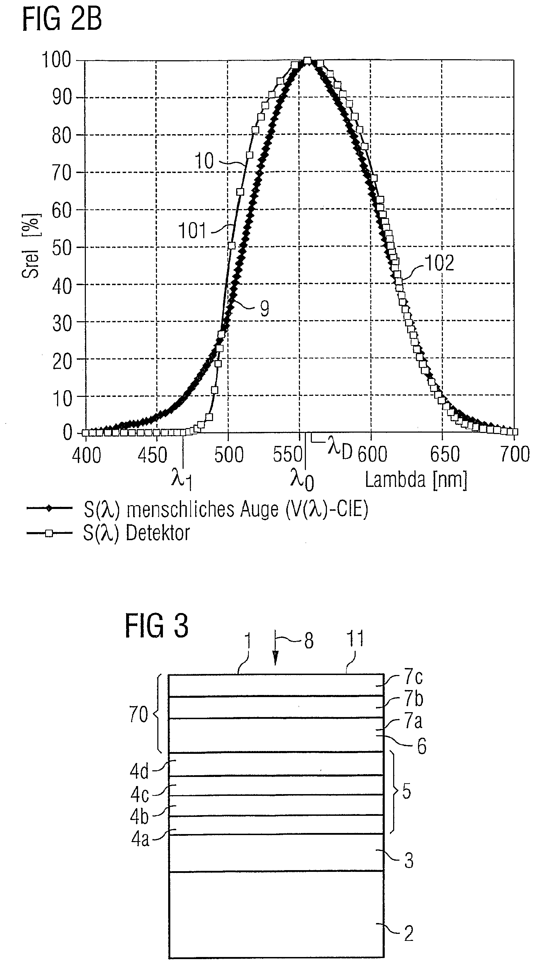

In Figur 2 ist der Verlauf der vorgegebenen Augenempfindlichkeit und der relativen Detektorempfindlichkeit (Srel) für zwei Varianten des ersten Ausführungsbeispiels eines erfindungsgemäßen Strahlungsdetektors in Abhängigkeit von der Wellenlänge der einfallenden Strahlung in den Figuren 2a bzw. 2b qualitativ dargestellt. Die Augenempfindlichkeit ist in Figur 2 durch die V(λ)-Kurve entsprechend der CIE (Commission Internationale l'Eclairage) dargestellt.

Die in den Figuren 2a und 2b gezeigten Abhängigkeiten wurden aus Simulationsrechnungen gewonnen, denen untenstehenden Zusammensetzungen des Halbleiterkörpers entsprechende Daten zu Grunde gelegt sind.

In der ersten Variante entsprechend Figur 2a umfasst der Strahlungsdetektor einen Halbleiterkörper gemäß Figur 1, der monolithisch integriert hergestellt ist und auf InₓGa_{y}Al_{1-x-y}P basiert. Auf einem Aufwachssubstrat 2 aus GaAs wird der Halbleiterkörper epitaktisch, beispielsweise mittels eines MOVPE-Verfahrens, gewachsen. Zunächst wird auf dem GaAshaltigen Substrat 2 eine ungefähr 100 nm dicke hochdotierte (n⁺) n-leitende Schicht 3 aus In_{0,5}Al_{0,5}P gewachsen. Nachfolgend wird der aktive Bereich 5 hergestellt, der die im wesentlichen undotierten Funktionsschichten 4a (In_{0,5}Ga_{0,5}P, Dicke ≈ 50 nm, E_{G} ≈ 1,91 eV, λ_{G} ≈ 650 nm), 4b (In_{0,5} (Ga_{0,9}Al_{0,1}) ₀,₅P, Dicke ≈ 100 nm, E_{G} ≈ 1, 97 eV, λ_{G} ≈ 630 nm), 4c (In_{0,5} (Ga_{0,7}Al_{0,3})_{0,5}P, Dicke ≈ 400 nm, E_{G} ≈ 2,07 eV, λ_{G} ≈ 600 nm), und 4d (In_{0,5}(Ga_{0,5}Al_{0,5})_{0,5}P, Dicke ≈ 500 nm, E_{G} ≈ 2,20 eV, λ_{G} ≈ 565 nm) umfasst. E_{G} bezeichnet hierbei die maßgebliche Bandlücke des jeweiligen Materials und λ_{G} die dieser Bandlücke entsprechende Wellenlänge. Nachfolgend wird eine ungefähr 100 nm dicke p-leitende hochdotierte (p⁺) In_{0,5}Al_{0,5}P Schicht 6 gefolgt von einer Filterschicht 7 hergestellt. Die von der n-leitenden 3 und der p-leitenden Schicht 6 hervorgerufene Raumladungszone erstreckt sich durch die Funktionsschichten. Die Filterschicht 7 ist außerhalb der Raumladungszone angeordnet.

Es sei angemerkt, dass der Al-Gehalt der Funktionsschichten von dem hier angeführten Gehalt abweichen kann. So kann beispielsweise auch mit Funktionsschichten, deren Al-Gehalt um 10% oder weniger, vorzugsweise um 5% oder weniger, von dem oben angeführten Al-Gehalt abweicht, gegebenenfalls ein Strahlungsdetektor gemäß der Augenempfindlichkeit realisiert werden.

In der ersten Variante gemäß Figur 2a ist die Filterschicht aus GaP und ungefähr 15 µm dick ausgebildet und die Detektorempfindlichkeit 10 bezogen auf die Augenempfindlichkeit 9 dargestellt.

Das Maximum der Augenempfindlichkeit und der Detektorempfindlichkeit fallen dabei nahezu zusammen, wobei λ_{D} leicht größer ist als λ₀. Die Abweichung dieser Wellenlängen voneinander beträgt bevorzugt 10 nm, besonders bevorzugt 5 nm, oder weniger. Die kurzwellige Seite 101 der Detektorempfindlichkeit 10 wird dabei durch die Filterschicht 7 bestimmt. Unterhalb einer Grenzwellenlänge λ₁ (≈ 455 - 465 nm) ist die Detektorempfindlichkeit nahezu Null. Diese Grenzwellenlänge entspricht ungefähr der direkten Bandlücke (E_{G} ≈ 2,73 eV) von GaP. Für Wellenlängen größer λ₁ bestimmt die Filterschicht 7 den Verlauf der kurzwelligen Seite der Detektorempfindlichkeit durch Absorption über ihre indirekte Bandlücke. Da GaP eine vergleichsweise flache Absorptionskante aufweist, ist die Filterschicht mit 15 µm relativ dick ausgeführt, um die Anpassung der Detektorempfindlichkeit an die vorgegebene Empfindlichkeitsverteilung im Wellenlängenbereich kleiner λ₀ zu erreichen.

Die langwellige Seite 102 der Detektorempfindlichkeit wird durch die Ausgestaltung der Funktionsschichten bestimmt. Für den Wellenlängenbereich von ungefähr 550 bis ungefähr 620 nm, in dem die Detektor- und die vorgegebene Empfindlichkeit hohe Werte aufweisen, sind die entsprechenden Funktionsschichten 4d und 4c wie oben dargelegt mit 500 nm bzw. 400 nm vergleichsweise dick ausgeführt, so dass im Strahlungsdetektor in diesem Wellenlängenbereich ein entsprechend hohes Photostromsignal erzeugt wird. Die Schicht 4b dagegen ist mit 100 nm vergleichsweise dünn ausgeführt, da für Wellenlängen im Bereich größer ungefähr 620 nm die Augenempfindlichkeit vergleichsweise gering ist. Im Bereich größer ungefähr 640 bis 680 nm, insbesondere bis 700 nm, sowie im µm-Bereich ist die Augenempfindlichkeit sehr gering und die entsprechende Funktionsschicht 4a ist deshalb mit 50 nm vergleichsweise dünn ausgeführt.

Der Strahlungsdetektor ist bevorzugt so ausgebildet, dass bei einer beliebigen vorgegebenen Wellenlänge die Abweichung der relativen Werte der Detektorempfindlichkeit von der vorgegebenen Empfindlichkeitsverteilung bevorzugt kleiner als 20%, besonders bevorzugt kleiner als 15% ist. Für Empfindlichkeitswerte größer als ungefähr 60% ist die Abweichung der beiden Empfindlichkeiten bei einer beliebigen vorgegebenen Wellenlänge bevorzugt kleiner als 10%, besonders bevorzugt kleiner als 5%.

Mit einer 15 µm dicken Filterschicht ist ein derartiger Halbleiterkörper 1 für einen Strahlungsdetektor jedoch vergleichsweise dick.

In der zweiten Variante gemäß Figur 2b ist die Filterschicht 7 im wesentlichen aus Al_{0,80}Ga_{0,20}As und ungefähr 1,5 µm dick ausgeführt.

Die langwellige Seite 102 der Detektorempfindlichkeit 10 ist wie in Figur 2a durch die Funktionsschichten bestimmt. Im Vergleich zu Figur 2a ist, aufgrund einer geänderten Zusammensetzung der Filterschicht, die Ausgestaltung der Funktionsschichten verändert. Bei der Simulationsrechnung für Figur 2b wurde folgende Ausgestaltung der Funktionsschichten zu Grunde gelegt: Funktionsschicht 4a (In_{0,5}Ga_{0,5}P, Dicke ≈ 50 nm, E_{G} ≈ 1,91 eV, λ_{G} ≈ 650 nm), Funktionsschicht 4b (In_{0,5}(Ga_{0,9}Al_{0,1})_{0,5}P, Dicke ≈ 100 nm, E_{G} ≈ 1,97 eV, λ_{G} ≈ 630 nm), Funktionsschicht 4c (In_{0,5}(Ga_{0,7}Al_{0,3})_{0,5}P, Dicke ≈ 300 nm, E_{G} ≈ 2,07 eV, λ_{G} ≈ 600 nm), und Funktionsschicht 4d (In_{0,5}(Ga_{0,5}Al_{0,5})_{0,5}P, Dicke ≈ 700 nm, E_{G} ≈ 2,20 eV, λ_{G} ≈ 565 nm). Unterschiede zur Ausgestaltung in Figur 2a zeigen sich in den Dicken der Funktionsschichten 4c und 4d, die aufgrund der geänderten Zusammensetzung der Filterschicht dünner bzw. dicker als gemäß den Ausführungen zu Figur 2a ausgebildet sind. Der grundsätzliche Verlauf der langwelligen Seite 102 der Detektorempfindlichkeit 10 aus Figur 2b stimmt im wesentlichen mit dem der in Figur 2a gezeigten Detektorempfindlichkeit überein.

Die durch die Filterschicht 7 bestimmte kurzwellige Seite 101 weicht in Figur 2b jedoch von dem in Figur 2a gezeigten Verlauf und der Augenempfindlichkeit 9 ab. Da die kurzwellige Seite in der Variante gemäß Figur 2b von einer AlGaAshaltigen Filterschicht bestimmt wird und Al_{0,80}Ga_{0,20}As eine verglichen mit GaP steilere Absorptionskante aufweist, ist der Verlauf der Detektorempfindlichkeit 10 im kurzwelligen Bereich 101 verglichen mit dem in Figur 2a gezeigten Verlauf steiler.

Das Maximum der Detektorempfindlichkeit λ_{D} liegt bei ungefähr 560 bis 565 nm und somit leicht rechts von dem der vorgegebenen spektralen Empfindlichkeitsverteilung des menschlichen Auges, das bei λ₀ ungefähr 555 nm liegt. Die kurzwellige Grenzwellenlänge λ₁ liegt bei ungefähr 475 nm bis 490 nm, was ungefähr der direkten Bandlücke (E_{G} ≈ 2,53 eV) von Al_{0,80}Ga_{0,20}As entspricht.

In Figur 3 ist ein zweites Ausführungsbeispiel eines erfindungsgemäßen Strahlungsdetektors anhand einer Schnittansicht schematisch dargestellt.

Im wesentlichen entspricht das zweite Ausführungsbeispiel gemäß Figur 3 dem in Figur 1 gezeigten ersten Ausführungsbeispiel. Im Unterschied hierzu ist eine Filterschichtstruktur 70 mit einer Mehrzahl von Filterschichten 7a, 7b und 7c im Halbleiterkörper 1 monolithisch integriert. Die Filterschichten weisen vorzugsweise unterschiedliche Bandlücken und/oder Dicken auf. Insbesondere kann die p-leitende Schicht 6 auch zur Filterung ausgebildet sein, was jedoch nicht zwingend notwendig ist. Bevorzugt ist zumindest eine, besonders bevorzugt sind alle, Filterschichten der Filterschichtstruktur hochdotiert, etwa p-leitend (p⁺).

Die Absorption in den Filterschichten der Filterschichtstruktur erfolgt im wesentlichen über eine direkte Bandlücke der jeweiligen Filterschicht. Im Gegensatz zum Ausführungsbeispiel gemäß Figur 1, in dem die Filterung und insbesondere die Anpassung der Detektorempfindlichkeit auf der kurzwelligen Seite hauptsächlich durch Absorption über die indirekte Bandlücke erfolgt, kann die Filterschichtstruktur gemäß Figur 3 vergleichsweise dünn ausgeführt sein. Insbesondere kann die Dicke der Filterschichtstruktur 70 insgesamt 1 µm, vorzugsweise 0,9 µm oder 0,8 µm, oder weniger betragen. Der Halbleiterkörper 1 ist weiterhin mit Vorzug monolithisch integriert ausgebildet.

Mit einer Verringerung der Dicke der Filterschichtstruktur sinken, etwa aufgrund verringerter Epitaxiezeiten, mit Vorteil die Herstellungskosten für einen derartigen Halbleiterkörper.

Insbesondere kann über eine Filterschichtstruktur 70 mit einer Mehrzahl von Filterschichten ein vergleichsweise schneller Abfall der Detektorempfindlichkeit im Bereich der direkten Bandlücke einer Filterschicht, etwa im Bereich um λ₁ in Figur 2a oder 2b, vermieden werden. Die Detektorempfindlichkeit kann somit auch im Bereich einer direkten Bandlücke einer Filterschicht oder im Bereich einer auslaufenden kurzwelligen Flanke der vorgegebenen spektralen Empfindlichkeitsverteilung verbessert an die vorgegebene Verteilung angepasst werden.

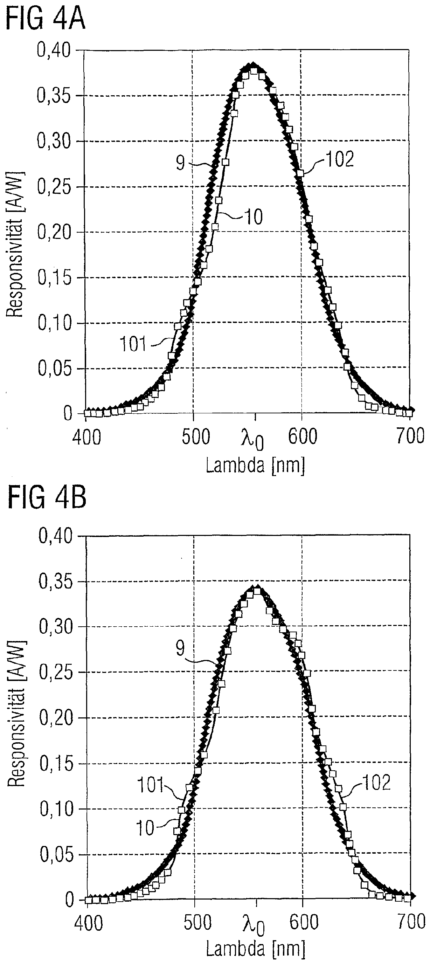

In Figur 4 ist der spektrale Verlauf der vorgegebenen Empfindlichkeitsverteilung des menschlichen Auges und der Detektorempfindlichkeit für zwei Varianten des zweiten Ausführungsbeispiels in den Figuren 4a und 4b qualitativ dargestellt.

In Figur 4 ist jeweils für die beiden Varianten des zweiten Ausführungsbeispiels die Responsivität des Strahlungsdetektors in Ampere des erzeugten Photostromes pro Watt der einfallenden Strahlungsleistung in Abhängigkeit von der Wellenlänge der auf den Strahlungsdetektor einfallenden Strahlung 8 aufgetragen. Relativ zur Responsivität ist die spektrale Empfindlichkeitsverteilung des menschlichen Auges dargestellt. Die in Figur 4 gezeigten Abhängigkeiten wurden wie in Figur 2 über entsprechende Simulationsrechnungen gewonnen.

Die langwellige Seite 102 der Detektorempfindlichkeit 10 gemäß den Figuren 4a und 4b wird durch die Funktionsschichten 4a,4b,4c und 4d im aktiven Bereich 5 bestimmt. In Figur 4a sind die Funktionsschichten gemäß den Ausführungen zu Figur 2a und in Figur 4b gemäß den Ausführungen zu Figur 2b ausgebildet.

Die langwellige Seite 102 verläuft im wesentlichen entsprechend der langwelligen Seite der vorgegebenen spektralen Empfindlichkeitsverteilung 9 des menschlichen Auges. Im wesentlichen entspricht der Verlauf der langwelligen Seiten in Figur 4 den in Figur 2 gezeigten Verläufen.

Unterschiede zeigen sich jedoch auf der kurzwelligen Seite 101 der Detektorempfindlichkeit. Verglichen mit der Detektorempfindlichkeit 10 in Figur 2a oder 2b ist die Anpassung aufgrund der Mehrzahl von Filterschichten unterschiedlicher Bandlücke und/oder Dicke in der Filterschichtstruktur vorteilhaft verbessert.

Es hat sich gezeigt, dass für die vorgegebene spektrale Empfindlichkeitsverteilung des menschlichen Auges eine Anzahl von drei Filterschichten 7a, 7b und 7c besonders vorteilhaft ist.

Die Detektorempfindlichkeit 10 gemäß Figur 4a ergibt sich etwa mittels einer Filterschichtstruktur, die eine Filterschicht 7a (In_{0,5}Al_{0,5}P, Dicke ≈ 400 nm), 7b (In_{0,5}(Ga_{0,3}Al_{0,7})_{0,5}P, Dicke ≈ 250 nm) und 7c (GaP, Dicke ≈ 100 nm) umfasst. Mit Vorzug ist, falls die p-leitende Schicht 6, wie in Figur 3 dargestellt, als Filterschicht 7a ausgebildet ist, die n-leitende Schicht 3 (In_{0,5}Al₀,₅P, Dicke ≈ 400 nm) in Zusammensetzung und Dicke entsprechend der p-leitenden Schicht 6 ausgeführt. Die Dicke der Filterschichtstruktur ergibt sich in der Folge als ungefähr 750 nm.

Bei der Wellenlänge λ₀ ≈ 555 nm des Maximums der Empfindlichkeit des helladaptierten Auges beträgt die Responsivität des Strahlungsdetektors mit Vorzug ungefähr 0,37 A/W. Auch für Wellenlängen kleiner ungefähr 460 nm ist eine Anpassung der Detektorempfindlichkeit an die vorgegebene spektrale Empfindlichkeitsverteilung aufgrund der Mehrzahl von Filterschichten 7a, 7b und 7c gegeben. Die GaP-haltige Filterschicht 7c ist verglichen mit der Filterschicht 7 gemäß Figur 2a sehr dünn ausgeführt und dient im wesentlichen als Kontaktschicht für einen nicht dargestellten und auf ihr angeordneten metallhaltiger Anschluss, da sich GaP durch vorteilhafte Kontakteigenschaften zu metallhaltigen Anschlüssen einerseits und zu Materialien aus dem III-V-Halbleitermaterialsystem InₓGa_{y}Al_{1-x-y}P andererseits auszeichnet.

Die p-leitende Schicht 6 ist als Filterschicht 7a zur Filterung verglichen mit den Varianten gemäß Figur 2a und 2b mit 400 nm vergleichsweise dick ausgeführt.

Eine Filterschichtstruktur 70 für einen Strahlungsdetektor mit einer Empfindlichkeit 10 gemäß Figur 4b umfasst beispielsweise eine Filterschicht 7a (In_{0,5}Al_{0,5}P, Dicke ≈ 400 nm), 7b (Al_{0,7}Ga_{0,3}As, Dicke ≈ 250 nm) und 7c (Al₀,₈Ga_{0,2}As, Dicke ≈ 200 nm). Das Maximum der Responsivität dieses Strahlungsdetektors liegt etwas unter dem des Detektors gemäß Figur 4a bei ungefähr 0,34 A/W. Die Gesamtdicke der Filterschichtstruktur beträgt ungefähr 850 nm.

In Figur 4b ist die kurzwellige Seite 101 auch im Bereich vergleichsweise geringer Wellenlängen, etwa kleiner als 490 nm, gut an die vorgegebene spektrale Empfindlichkeitsverteilung 9 angepasst.

Insgesamt kann mittels einer Mehrzahl von Filterschichten und Absorption im wesentlichen über die direkten Bandlücken der Filterschichten die Anpassung der Detektorempfindlichkeit an die vorgegebene spektrale Empfindlichkeitsverteilung verbessert werden. Gleichzeitig wird eine vorteilhaft geringe Dicke der Filterschichtstruktur erzielt.

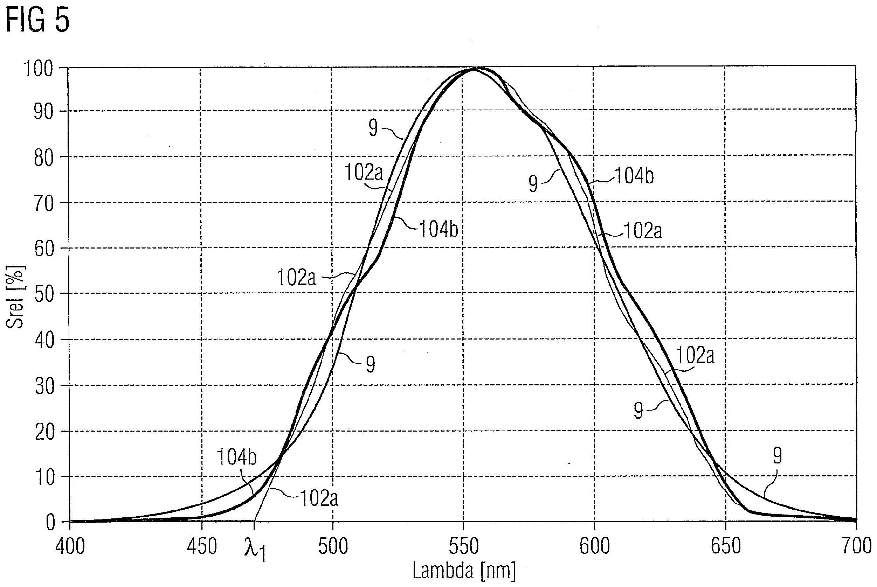

In Figur 5 sind zum Vergleich der Ausführungsbeispiele gemäß Figur 1 und Figur 3 die Empfindlichkeit 102a eines Strahlungsdetektors gemäß Figur 2a, die Empfindlichkeit 104b eines Strahlungsdetektors gemäß Figur 4b und die vorgegebene spektrale Empfindlichkeit 9 des menschlichen Auges relativ zueinander quantitativ dargestellt. Die Detektorempfindlichkeiten basieren auf Empfindlichkeitsmessungen, die für Strahlungsdetektoren mit entsprechend gefertigten Halbleiterkörpern durchgeführt wurden.

Bei der Kurve 102a tritt eine durch die vergleichsweise dicke, auf GaP basierende Filterschicht bedingte kurzwellige Grenze λ₁ auf, jenseits derer die Detektorempfindlichkeit im wesentlichen vernachlässigbar ist. Bei der Kurve 104b dagegen ist, aufgrund der Filterschichtstruktur mit der Mehrzahl von Filterschichten, auch im Bereich von Wellenlängen kleiner als λ₁ eine gute Anpassung der Detektorempfindlichkeit an die Augenempfindlichkeit gegeben.

Der Strahlungsdetektor kann bei der Erfindung insbesondere derart ausgebildet werden, dass bei einer beliebigen vorgegebenen Wellenlänge die relative Detektorempfindlichkeit und die vorgegebene spektrale Empfindlichkeitsverteilung um 20 %, bevorzugt 10%, besonders bevorzugt 5%, oder weniger voneinander abweichen.

Es sei angemerkt, dass die Erfindung nicht auf Strahlungsdetektoren gemäß der Augenempfindlichkeit beschränkt ist. Durch geeignete Ausbildung der Funktionsschichten und der Filterschicht können auch weitere Detektorempfindlichkeiten, beispielsweise gemäß einer vorgegebenen spektralen Rechteckverteilung, realisiert werden. Weiterhin ist die Anzahl der Funktionsschichten - vier Funktionsschichten im Ausführungsbeispiel - nicht als beschränkend anzusehen. Es kann auch eine hiervon abweichende Anzahl von Funktionsschichten in einem erfindungsgemäßen Strahlungsdetektor vorgesehen sein.

Weiterhin sei angemerkt, dass die Funktionsschichten des aktiven Bereichs bei der Erfindung nicht notwendigerweise in einer für die jeweilige Funktionsschicht charakteristischen, festen Zusammensetzung nacheinander hergestellt werden müssen, etwa in den weiter oben angegebenen Zusammensetzungen der Funktionsschichten 4a, 4b, 4c und 4d mit jeweiligem Al-Gehalt.

Vielmehr können die Funktionsschichten auch in einem Funktionsbereich mittels gezielter Variation eines Herstellungsparameters beim Herstellen des Funktionsbereichs ausgebildet sein. Bevorzugt kann über den Herstellungsparameter die Bandlücke im Funktionsbereich, besonders bevorzugt während der Epitaxie und in Wachstumsrichtung, variiert werden. Der Herstellungsparameter kann abschnittsweise oder insgesamt kontinuierlich, vorzugsweise linear, variiert werden. Mit Vorzug wird der Herstellungsparameter von einem vorgegebenen Anfangs- bis zu einem vorgegebenen Endwert variiert. Anfangs- und Endwert hängen dabei von der vorgegebenen spektralen Empfindlichkeitsverteilung ab.

Für Wellenlängenbereiche, in denen eine relativ hohe Signalstärke erwünscht ist, kann der Herstellungsparameter bei der Epitaxie in Bezug auf die Wachstumsgeschwindigkeit in vertikaler Richtung vergleichsweise langsam variiert werden, so dass im Funktionsbereich eine "Funktionsschicht" vergleichsweise hoher "Dicke" ausgebildet wird, über deren vertikalen Verlauf sich der Herstellungsparameter nur relativ langsam ändert oder im wesentlichen konstant ist.

Beispielsweise kann der Al-Gehalt entsprechend den Funktionsschichten 4a, 4b, 4c und 4d eines Strahlungsdetektors aus Figur 1 mit einem Verlauf der Detektorempfindlichkeit gemäß Figur 2a oder 2b für die vorgegebene spektrale Empfindlichkeitsverteilung des menschlichen Auges während der Herstellung eines Funktionsbereichs kontinuierlich von 0 (Anfangswert) über 0,1 und 0,3 bis 0,5 (Endwert) variiert werden, wobei für eine dicker ausgeführte Funktionsschicht der Al-Gehalt in Bezug auf die Wachstumsgeschwindigkeit der Funktionsschicht langsamer variiert wird als bei einer dünner ausgeführten Funktionsschicht.

Im Wertebereich zwischen den für Funktionsschichten gewünschten Werten des Herstellungsparameters - zum Beispiel zwischen einem Al-Gehalt von 0,1 und 0,3 - wird der Herstellungsparameter in Bezug auf die Wachstumsgeschwindigkeit vorzugsweise vergleichsweise schnell variiert.

Ein derartiger mittels Variation eines Herstellungsparameters ausgebildeter Funktionsbereich kann als graded index separate confinement heterostructure (kurz: Grinsch-Struktur) ausgeführt sein. Der Begriff "graded index" bezieht sich auf eine, etwa graduelle, Variation des Herstellungsparameters, die oftmals mit einer Änderung des Brechungsindexes einher geht. Etwaige Barriereschichten für Ladungsträger im Funktionsbereich können außerhalb des Funktionsbereichs ausgebildet werden (separate confinement) und insgesamt kann der Funktionsbereich als Heterostruktur (heterostructure) ausgebildet sein.

Ein mittels Variation eines Herstellungsparameters ausgebildeter Funktionsbereich ist mit Vorteil vergleichsweise tolerant gegenüber Schwankungen oder leichten Abweichungen von für die Funktionsschichten gewünschten Werten des Herstellungsparameters während der Herstellung des Funktionsbereichs. Bei separat nacheinander hergestellten Funktionsschichten mit jeweils getrennt eingestelltem konstantem Herstellungsparameter besteht die Gefahr, dass geringe Abweichungen vom Wert des Herstellungsparameters bereits vergleichsweise große Abweichungen der spektralen Empfindlichkeitsverteilung des Detektors von der vorgegebenen spektralen Empfindlichkeitsverteilung nach sich ziehen. Mittels einer Herstellung eines Funktionsbereichs über Variation eines Herstellungsparameters von einem Anfangs- zu einem Endwert, kann diese Gefahr verringert werden. Es müssen lediglich über die vorgegebene spektrale Emfindlichkeitsverteilung vorgegebene Anfangs- und Endwerte bei der Herstellung des Funktionsbereichs vergleichsweise genau realisiert werden, während im Bereich zwischen diesen Werten die Toleranz gegenüber Abweichungen von für Funktionsschichten gewünschten Werten vorteilhaft erhöht ist.

## Patentansprüche

1. Strahlungsdetektor zur Detektion von Strahlung (8) , wobei der Strahlungsdetektor eine vorgegebene spektrale Empfindlichkeitsverteilung (9) hat, die ein Maximum bei einer vorgegebenen Wellenlänge λ₀ aufweist, wobei die vorgegebene spektrale Empfindlichkeitsverteilung (9) die des helladaptierten oder dunkeladaptierten menschlichen Auges ist,
- umfassend einen Halbleiterkörper (1) mit einem der Detektorsignalerzeugung dienenden und zum Strahlungsempfang vorgesehenen aktiven Bereich (5), wobei die Struktur des Halbleiterkörpers einer pin-Diodenstruktur entspricht,
- der aktive Bereich (5) eine Mehrzahl von Funktionsschichten (4a,4b,4c,4d) umfasst, wobei die Funktionsschichten unterschiedliche Bandlücken aufweisen,
- entweder die Funktionsschichten derart ausgebildet sind, dass diese Funktionsschichten zumindest teilweise Strahlung in einem Wellenlängenbereich absorbieren, der Wellenlängen größer als die Wellenlänge λ₀ umfasst, oder
- der Halbleiterkörper (1) mindestens ein III-V-Halbleitermaterial enthält,
- dem aktiven Bereich (5) eine Filterschichtstruktur (70) nachgeordnet ist, sodass vom Strahlungsdetektor zu empfangende Strahlung teilweise durch die Filterschichtstruktur (70) hindurchtritt und nach dem Hindurchtreten zur Signalerzeugung auf den aktiven Bereich (5) trifft, wobei
- die Filterschichtstruktur (70) zumindest eine Filterschicht (7,7a,7b,7c) umfasst, und
- die Filterschichtstruktur (70) die kurzwellige Seite (101) einer Detektorempfindlichkeit (10) gemäß der vorgegebenen spektralen Empfindlichkeitsverteilung (9) durch Absorption von Strahlung in einem Wellenlängenbereich bestimmt, der Wellenlängen kleiner als λ₀ umfasst,
- der Halbleiterkörper (1) mit der Filterschichtstruktur (70) monolithisch integriert ist, und
- die durch Absorption von Strahlung in der Filterschicht (7,7a,7b,7c) erzeugten Elektron-Loch-Paare im Wesentlichen nicht zum Photostrom beitragen.

2. Strahlungsdetektor nach dem vorhergehenden Anspruch 1,
**dadurch gekennzeichnet, dass**
die Filterschichtstruktur (70) eine einzelne Filterschicht (7) umfasst, die eine direkte Bandlücke und eine indirekte Bandlücke aufweist.

3. Strahlungsdetektor nach dem vorhergehenden Anspruch 2,
**dadurch gekennzeichnet, dass**
die direkte Bandlücke größer ist als die Bandlücke einer der Filterschicht (7) seitens des aktiven Bereichs (5) nachgeordneten Funktionsschicht.

4. Strahlungsdetektor nach einem der Ansprüche 2 oder 3,
**dadurch gekennzeichnet, dass**
die Filterschicht (7) durch Absorption von Strahlung über die indirekte Bandlücke in einem Wellenlängenbereich, der Wellenlängen kleiner als λ₀ umfasst, die kurzwellige Seite der Detektorempfindlichkeit bestimmt.

5. Strahlungsdetektor nach einem der Ansprüche 2 bis 4,
**dadurch gekennzeichnet, dass**
die direkte Bandlücke eine kurzwellige Grenze der Detektorempfindlichkeit bestimmt.

6. Strahlungsdetektor nach einem der Ansprüche 2 bis 5,
**dadurch gekennzeichnet, dass**
die Dicke der Filterschicht (7) mehr als 1µm beträgt.

7. Strahlungsdetektor nach Anspruch 1, **dadurch gekennzeichnet, dass**
die Filterschichtstruktur (70) eine Mehrzahl von Filterschichten (7a,7b,7c) unterschiedlicher Bandlücke und/oder Dicke aufweist.

8. Strahlungsdetektor nach Anspruch 7,
**dadurch gekennzeichnet, dass**
die Filterschichtstruktur (70) über Absorption von Strahlung über eine direkte Bandlücke der jeweiligen Filterschicht (7a,7b,7c) in einem Wellenlängenbereich, der Wellenlängen kleiner als λ₀ umfasst, die kurzwellige Seite der Detektorempfindlichkeit (10) bestimmt.

9. Strahlungsdetektor nach Anspruch 7 oder 8,
**dadurch gekennzeichnet, dass**
die Filterschichtstruktur (70) eine Dicke von 1 µm oder weniger aufweist.

10. Strahlungsdetektor nach mindestens einem der vorhergehenden Ansprüche,
**dadurch gekennzeichnet, dass**
der aktive Bereich (5) InₓGa_{y}Al_{1-x-y}P, InₓGa_{y}Al_{1-x-y}As oder InₓGa_{y}Al_{1-x-y}N, jeweils mit 0≤x≤1, 0≤y≤1 und x+y≤1, enthält.

11. Strahlungsdetektor nach mindestens einem der vorhergehenden Ansprüche,
**dadurch gekennzeichnet, dass**
die Funktionsschichten (4a,4b,4c,4d) über ihre Ausgestaltung die langwellige Seite (102) der Detektorempfindlichkeit (10) für Wellenlängen größer als λ₀ gemäß der vorgegebenen spektralen Empfindlichkeitsverteilung (9) bestimmen.

12. Strahlungsdetektor nach mindestens einem der vorhergehenden Ansprüche,
**dadurch gekennzeichnet, dass**
die Bandlücke von im Halbleiterkörper (1) nachgeordneten Funktionsschichten (4a,4b,4c,4d) zumindest teilweise in Richtung der einfallenden Strahlung (8) zunimmt.

13. Strahlungsdetektor nach mindestens einem der vorhergehenden Ansprüche,
**dadurch gekennzeichnet, dass**
der aktive Bereich (5) zumindest eine Heterostruktur umfasst.

14. Strahlungsdetektor nach mindestens einem der vorhergehenden Ansprüche, **dadurch gekennzeichnet, dass** die Funktionsschichten (4a,4b,4c,4d) unterschiedliche Dicken aufweisen.

## Claims

1. Radiation detector that detects radiation (8) according to a predefined spectral sensitivity distribution (9) that exhibits a maximum at a predefined wavelength λ₀, wherein the spectral sensitivity distribution (9) is the spectral sensitivity distribution of the light adapting or dark adapting human eye,
- comprising a semiconductor body (1) with an active region (5) serving to generate a detector signal and intended to receive radiation, wherein the semiconductor body corresponds to a PIN diode structure,
- the active region (5) comprises a plurality of functional layers (4a,4b,4c,4d), wherein the functional layers have different band gaps,
- either the functional layers are formed such that these functional layers absorb radiation on a wavelength range that includes wavelength greater than the wavelength λ₀, or
- the semiconductor body (1) contains at least one III-V semiconductor material,
- disposed after the active region (5) is a filter layer structure (70), such that radiation to be received by the radiation detector partially passes the filter layer structure (70) and after passing the filter layer structure hits the active region (5) for generating the detector signal, wherein
- the filter layer structure (70) contains at least one a filter layer (7,7a,7b,7c), and
- the filter layer structure (70) determines a short-wave side (101) of a detector sensitivity (10) in accordance with the predefined spectral sensitivity distribution (9) by absorbing radiation in a wavelength range that includes wavelengths smaller than λ₀,
- the semiconductor body (1) is monolithically integrated with the filter layer structure (70), and
- electron-hole pairs generated by absorption in the filter layer (7,7a,7b,7c) do not substantially contribute to the photocurrent.

2. Radiation detector according to the preceding claim 1,
**characterized in that**
the filter layer structure (70) comprises a single filter layer (7) which has a direct band gap and an indirect bandgap.

3. Radiation detector according to the preceding claim 2,
**characterized in that**
the direct band gap is larger than a band gap of a functional layer disposed after the filter layer (7) on the side nearer the active region (5).

4. Radiation detector according to one of the claims 2 or 3,
**characterized in that**
the filter layer (7) determines the short-wave side of said detector sensitivity by absorbing radiation via the indirect band gap in a wavelength range that includes wavelengths smaller than λ₀.

5. Radiation detector according to one of the claims 2 to 4,
**characterized in that**
the direct band gap determines a short-wave limit of the detector sensitivity.

6. Radiation detector according to one of the claims 2 to 5,
**characterized in that**
the thickness of the filter layer (7) is greater than 1 µm.

7. Radiation detector according to claim 1,
**characterized in that**
the filter layer structure (70) comprises a plurality of filter layers (7a,7b,7c) of different band gaps and/or thicknesses.

8. Radiation detector according to claim 7,
**characterized in that**
the filter layer structure (70) determines the short-wave side of the detector sensitivity (10) by absorbing radiation via a direct band gap of the respective filter layer (7a, 7b, 7c) in a wavelength range that includes wavelengths smaller than λ₀.

9. Radiation detector according to claim 7 or 8,
**characterized in that**
the filter layer structure (70) has a thickness of 1 µm or less.

10. Radiation detector according to at least one of the preceding claims,
**characterized in that**
the active region (5) contains InₓGa_{y}Al_{1-x-y}P, InₓGa_{y}Al_{1-x-y}As, or InₓGa_{y}Al_{1-x-y}N, wherein in each case 0≦x≦1, 0≦y≦1 and x+y≦1.

11. Radiation detector according to at least one of the preceding claims,
**characterized in that**
the functional layers (4a,4b,4c,4d) determine by their implementation the long-wave side (102) of the detector sensitivity (10) in accordance with the predefined spectral sensitivity distribution (9) for wavelengths greater than λ₀.

12. Radiation detector according to at least one of the preceding claims,
**characterized in that**
band gaps of functional layers (4a,4b,4c,4d) disposed one after the other in the semiconductor body (1) at least partially increase in the direction of the incident radiation (8).

13. Radiation detector according to at least one of the preceding claims,
**characterized in that**
the active region (5) comprises at least one heterostructure.

14. Radiation detector according to at least one of the preceding claims,
**characterized in that**
the functional layers (4a,4b,4c,4d) have different thicknesses.

## Revendications

1. Détecteur de rayonnement en vue de la détection de rayonnement (8), sachant que le détecteur de rayonnement possède une répartition de sensibilité spectrale prescrite (9), qui présente un maximum à une longueur d'ondes prescrite λ₀, sachant que la répartition de sensibilité spectrale prescrite (9) est celle de l'œil humain adapté à la lumière ou adapté à l'obscurité,
- comportant un corps de semiconducteur (1) avec une région active (5) servant à la génération de signaux de détecteur et prévue pour la réception de rayonnement, sachant que la structure du corps de semiconducteur correspond à une structure de diode pin,
- la région active (5) comporte une pluralité de couches fonctionnelles (4a, 4b, 4c, 4d), sachant que les couches fonctionnelles présentent différents écarts énergétiques,
- soit les couches fonctionnelles sont constituées de sorte que lesdites couches fonctionnelles absorbent au moins partiellement du rayonnement dans une plage de longueurs d'ondes qui comporte des longueurs d'ondes supérieures à la longueur d'ondes λ₀, soit
- le corps de semiconducteur (1) contient au moins un matériau de semiconducteur III-V,
- en aval de la région active (5) est disposée une structure de couches filtrantes (70), de sorte que le rayonnement à recevoir par le détecteur de rayonnement pénètre partiellement à travers la structure de couches filtrantes (70) et après la pénétration, touche la région active (5) en vue de la génération de signaux, sachant que
- la structure de couches filtrantes (70) comporte au moins une couche filtrante (7, 7a, 7b, 7c), et
- la structure de couches filtrantes (70) détermine le côté à ondes courtes (101) d'une sensibilité de détecteur (10) selon la répartition de sensibilité spectrale prescrite (9) par absorption de rayonnement dans une plage de longueur d'ondes, qui comporte des longueurs d'ondes inférieures à λ₀,
- le corps de semiconducteur (1) est intégré monolithiquement avec la structure de couches filtrantes (70), et
- les paires électron-trou générées par absorption de rayonnement dans la couche filtrante (7, 7a, 7b, 7c) ne contribuent pas pour l'essentiel au courant photoélectrique.

2. Détecteur de rayonnement selon la revendication précédente 1,
**caractérisé en ce que**
la structure de couches filtrantes (70) comporte une couche filtrante individuelle (7), qui présente un écart énergétique direct et un écart énergétique indirect.

3. Détecteur de rayonnement selon la revendication précédente 2,
**caractérisé en ce que**
l'écart énergétique direct est supérieur à l'écart énergétique d'une couche fonctionnelle disposée en aval de la couche filtrante (7) du côté de la région active (5).

4. Détecteur de rayonnement selon une quelconque des revendications 2 ou 3,
**caractérisé en ce que**
la couches filtrante (7) détermine le côté à ondes courtes de la sensibilité de détecteur (10) par absorption de rayonnement par l'intermédiaire de l'écart énergétique indirect dans une plage de longueurs d'ondes qui comporte des longueurs d'ondes inférieures à λ₀.

5. Détecteur de rayonnement selon une quelconque des revendications 2 à 4,
**caractérisé en ce que**
l'écart énergétique direct détermine une limite à ondes couches de la sensibilité de détecteur.

6. Détecteur de rayonnement selon une quelconque des revendications 2 à 5,
**caractérisé en ce que**
l'épaisseur de la couche de liaison (7) s'élève à plus de 1 µm.

7. Détecteur de rayonnement selon la revendication 1,
**caractérisé en ce que**
la structure de couches filtrantes (70) présente une pluralité de couches filtrantes (7a, 7b, 7c) d'écart énergétique et/ou d'épaisseur différents.

8. Détecteur de rayonnement selon la revendication 7,
**caractérisé en ce que**
la structure de couches filtrantes (70) détermine le côté à ondes courtes de la sensibilité de détecteur (10) par absorption de rayonnement via un écart énergétique direct de la couche filtrante respective (7a, 7b, 7c) dans une plage de longueurs d'ondes qui comporte des longueurs d'ondes inférieures à λ₀.

9. Détecteur de rayonnement selon les revendications 7 ou 8,
**caractérisé en ce que**
la structure de couches filtrantes (70) présente une épaisseur de 1 µm ou moins.

10. Détecteur de rayonnement selon au moins une quelconque des revendications précédentes,
**caractérisé en ce que**
la zone active (5) contient de l'InₓGa_{y}Al_{1-x-y}P, de l'InₓGa_{y}Al_{1-x-y}As ou de l'InₓGa_{y}Al_{1-x-y}N, respectivement avec 0≤x≤1, 0≤y≤1 et x+y≤1.

11. Détecteur de rayonnement selon au moins une quelconque des revendications précédentes,
**caractérisé en ce que**
les couches fonctionnelles (4a, 4b, 4c, 4d) déterminent via leur configuration le côté à grande longueur d'ondes (102) de la sensibilité de détecteur (10) pour les longueurs d'ondes supérieures à λ₀ selon la répartition de sensibilité spectrale prescrite (9).

12. Détecteur de rayonnement selon au moins une quelconque des revendications précédentes,
**caractérisé en ce que**
l'écart énergétique des couches fonctionnelles (4a, 4b, 4c, 4d) disposées en aval dans le corps de semiconducteur (1) augmente au moins partiellement dans la direction du rayonnement incident (8).

13. Détecteur de rayonnement selon au moins une quelconque des revendications précédentes,
**caractérisé en ce que**
la région active (5) comporte au moins une hétérostructure.

14. Détecteur de rayonnement selon au moins une quelconque des revendications précédentes,
**caractérisé en ce que**
les couches fonctionnelles (4a, 4b, 4c, 4d) présentent des épaisseurs différentes.
